# EUROPEAN PATENT APPLICATION

(11) **EP 4 646 046 A1**
(43) Date of publication of application: **05.11.2025**
(21) Application number: 25162529.9
(22) Date of filing: 10.03.2025
(51) Int. Cl.: H05K 7/20

(54) **LIQUID-COOLED POWER SUPPLY CHASSIS AND LIQUID-COOLED POWER SUPPLY CABINET AND DATA CENTER COOLING SYSTEM USING THE SAME**

(30) Priority: 03.05.2024 US 202463641967 P; 16.10.2024 TW 113139326
(71) Applicant: Lite-On Technology Corporation, Neihu, Taipei 114 (TW)
(72) Inventor: LEE, Chien-Chih, 114 Taipei (TW); CHEN, Wen-Chi, 114 Taipei (TW); CHU, Shu-Wei, 114 Taipei (TW); MAU, Shu-Hua, 114 Taipei (TW)
(74) Representative: Dompatent Partnerschaft von Patent- und Rechtsanwälten mbB

(57) **Abstract**

A liquid-cooled power supply chassis and a liquid-cooled power supply cabinet and a data center cooling system using the same are provided. The liquid-cooled power supply chassis includes a chassis, at least one power supply, and at least one partition. The chassis has a coolant input terminal and a coolant output terminal. The power supply is installed in the chassis. The partition is disposed in the chassis, and the partition separates the coolant input terminal from the coolant output terminal.

## Description

### BACKGROUND OF THE INVENTION

### Field of the Invention

The present invention relates in general to a liquid-cooled architecture, and more particularly to a liquid-cooled power supply chassis and a liquid-cooled power supply cabinet and a data center cooling system using the same.

### Description of the Related Art

Conventional liquid-cooled architectures require the addition of active cold plate or copper heat sinks in the cabinet, through which heat is transferred to a coolant, and then the coolant carries the heat away from the cabinet. However, installation of the cooling panels or copper heat sinks in the cabinet space will take up the original space of the cabinet and reduce the space utilization of the cabinet. In addition, conventional liquid-cooled architecture uses water as the coolant, which is a conductive medium that may cause leakage and short-circuit hazards, and such problems are required to be improved.

### SUMMARY OF THE INVENTION

The present invention relates to a liquid-cooled power supply chassis and a liquid-cooled power supply cabinet and a data center cooling system using the liquid-cooled power supply chassis, which can dissipate heat through liquid cooling and solve the shortcomings of conventional liquid-cooled architecture at the same time.

According to one aspect of the present invention, a liquid-cooled power supply chassis includes a chassis, at least one power supply, and at least one partition. The chassis has a coolant input terminal and a coolant output terminal. The power supply is installed in the chassis. The partition is disposed in the chassis, and the partition separates the coolant input terminal from the coolant output terminal.

According to one aspect of the present invention, a liquid-cooled power supply cabinet includes a shelf, a coolant input manifold, a coolant output manifold, at least one liquid-cooled power supply chassis, at least one first conduit, and at least one second conduit. The shelf has a reservoir, a first port, and a second port. The coolant input manifold has at least one inlet end that is connected to the first port. The coolant output manifold has at least one outlet end that is connected to the second port. The liquid-cooled power supply chassis is disposed in the reservoir of the shelf. The first conduit is connected between the first port and the coolant input terminal. The second conduit is connected between the second port and the coolant output terminal.

According to one aspect of the present invention, a data center cooling system includes at least one liquid-cooled power supply cabinet and at least one server cabinet. The liquid-cooled power supply cabinet has a plurality of power supply chassis, a first coolant input manifold, a first coolant output manifold, and a first coolant distribution unit. The server cabinet has a plurality of server chassis, a second coolant input manifold, a second coolant output manifold, and a second coolant distribution unit. Through the configuration of the first coolant distribution unit, a coolant is transferred into the plurality of power supply chassis via the first coolant input manifold and out of the plurality of power supply chassis via the first coolant output manifold. Through the configuration of the second coolant distribution unit, the coolant is transferred into the plurality of the server chassis via the second coolant input manifold and out of the plurality of server chassis via the second coolant output manifold.

The above and other aspects of the invention will become better understood with regard to the following detailed description of the preferred but non-limiting embodiment(s). The following description is made with reference to the accompanying drawings.

### BRIEF DESCRIPTION OF THE DRAWINGS

FIG. 1 illustrates a top view of a liquid-cooled power supply chassis in accordance with an embodiment of the present invention.
Figures 2A to 2B illustrate schematic diagrams of a partition in accordance with two embodiments of the present invention.
Figures 3A to 3C illustrate schematic diagrams of partitions in accordance with three embodiments of the present invention, respectively.
Figures 4 to 10 illustrate schematic diagrams of a partition in accordance with seven embodiments of the present invention, respectively.
Figures 11A and 11B illustrate a schematic diagram and a partially enlarged diagram of a liquid-cooled power supply cabinet in accordance with an embodiment of the present invention, respectively.
Figures 12 and 13 illustrate schematic diagrams of a liquid-cooled power supply cabinet having a built-in coolant distribution unit in accordance with an example of the present invention, respectively.
Figures 14 and 15 illustrate schematic diagrams of a liquid-cooled power cabinet (or server cabinet) and a data center cooling system with an external coolant distribution unit in accordance with an example of the present invention, respectively.
Figure 16 illustrates a schematic diagram of an AC power input to a power supply and a DC power output from the power supply.

### DETAILED DESCRIPTION OF THE INVENTION

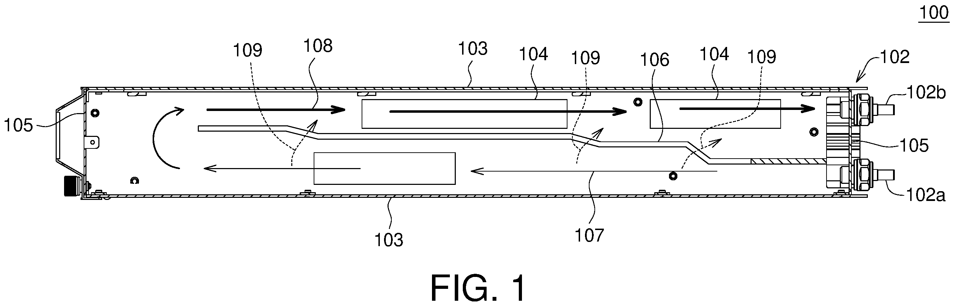

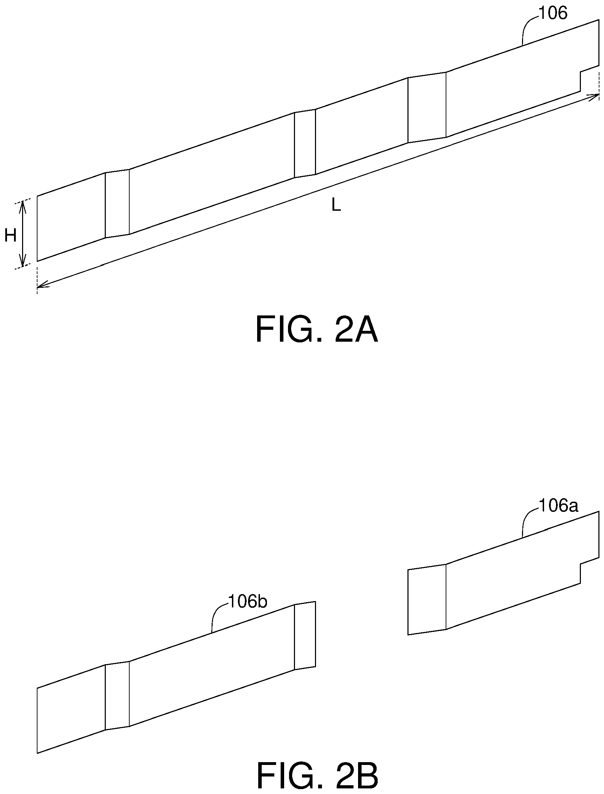

Referring to FIG. 1 and FIGS. 2A to 2B, FIG. 1 illustrates a top view of a liquid-cooled power supply chassis 100 in accordance with an embodiment of the present invention, and FIGS. 2A to 2B illustrate schematic diagrams of a partition 106 in accordance with two embodiments of the present invention, respectively.

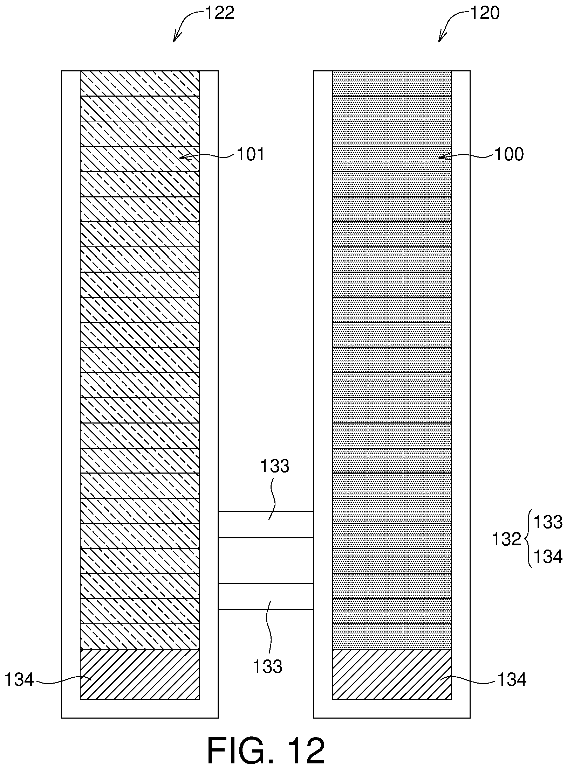

The liquid-cooled power supply chassis 100 adopts a heat dissipation method using a liquid as the heat conduction medium, or, in other words, an immersion cooling method in which the heating element is directly immersed in a non-conducting coolant, so that the heat generated by the heating element can be directly transmitted to the coolant without the need of any active cold plates or copper heat sinks. The coolant can flow out of the liquid-cooled power supply chassis 100 through the conduits and then return to the liquid-cooled power supply chassis 100 through the cooling cycle to absorb the heat generated by the heating element again in order to improve the heat dissipation efficiency. The liquid-cooled power supply chassis 100 of the present embodiment may be used in a liquid-cooled power supply cabinet 120, a server cabinet 122, and/or a data center cooling system 140 with the liquid-cooled power supply cabinet 120 and the server cabinet 122 (refer to FIGS. 12 to 15).

In one embodiment, the coolant is a dielectric fluid, which is commonly used as synthetic oil (Hydrocarbons) or fluoride (Fluorochemicals). The coolant is a non-conducting medium, which eliminates the risk of short circuits due to leakage.

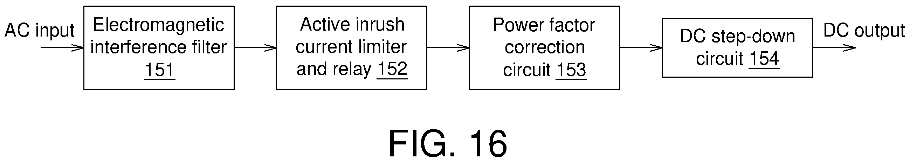

Referring to FIG. 1, the liquid-cooled power supply chassis 100 includes a chassis 102, at least one power supply 104, and at least one partition 106. The chassis 102 has a closed housing in which components, circuit boards, and heating elements can be stored. The power supply 104 comprises a power converter and/or a transformer to provide operating voltage and power for the electrical components. The partition 106, for example, is a flow-conducting plate and/or a flow-dividing plate, which is used to divide the interior space of the chassis 102 into multiple zones to facilitate the flow of the coolant inside the chassis 102. Alternatively, circuit boards for mounting electronic elements within the chassis 102 may be utilized as part of the partition 106. The coolant must at least partially cover the electronic components such as circuit boards, power converters and/or transformers. For example, at least 50-100% of the chassis 102 is filled with the coolant, but the coolant is not completely filled with the chassis 102. The power supply 104 receives alternating current (AC) input, which passes through an electromagnetic interference filter (EMI filter) 151, an active inrush current limiter and relay 152, a power factor correction (PFC) circuit 153, a DC-to-DC converter circuit 154 and the like, and finally outputs a direct current (DC) power, as shown in FIG. 16.

Referring to FIG. 1, the chassis 102 is, for example, a rectangular chassis. The chassis 102 has two long sides 103 and two short sides 105 on opposite sides of the chassis 102, respectively. In addition, the chassis 102 has a coolant input terminal 102a and a coolant output terminal 102b, which correspond to the same short side 105 of the chassis 102. The coolant input terminal 102a is used for coolant to enter the chassis 102. The coolant output terminal 102b is used to discharge the coolant out of the chassis 102. However, in other embodiments, the coolant input terminal 102a may be located on one of the short sides 105 of the chassis 102, and the coolant output terminal 102b may be located on another one of the short sides 105 of the chassis 102. Therefore, the chassis 102 disclosed in the embodiment is not limited to having the coolant input terminal 102a and the coolant output terminal 102b located on the same short side105.

Referring to FIG. 1, the partition 106 is disposed in the chassis 102, and the partition 106 separates the coolant input terminal 102a from the coolant output terminal 102b, i.e., the partition 106 extends along the long side 103 of the chassis 102 and is disposed between the coolant input terminal 102a and the coolant output terminal 102b so as to divide the internal space of the chassis 102 into at least two areas for direct-flow fields 107 and 108.

As shown in FIG. 1, the coolant input terminal 102a corresponds to a direct-flow field 107 on one side of the partition 106, and the coolant output terminal 102b corresponds to another direct-flow field 108 on the other side of the partition 106. In an embodiment, the coolant, for example, flows through in the interior of the chassis 102 through the two direct-flow fields 107, 108 connected in a U-shape, allowing the heat generated by the heating elements inside the chassis 102 to be directly transferred by the coolant, and then conducts the heat out of the chassis 102 through the coolant. However, in other embodiments, the coolant flows inside the chassis 102 via other types of flow fields (e.g., S-shaped, V-shaped, W-shaped, or other shapes).

Since the coolant flows from the direct-flow field 107 first to the direct-flow field 108, the coolant absorbs the heat of the electronic elements in the area when passing through the direct-flow field 107. Therefore, the temperature of the coolant in the direct-flow field 108 is higher than that in the direct-flow field 107. If heat-generating component is arranged in the direct-flow field 107, the temperature of the coolant in the area of the direct-flow field 107 significantly increases. When the coolant flows to the direct flow field 108, the heat exchange efficiency between the coolant and the electronic components may be reduced due to the small temperature difference between the coolant and the electronic components in the direct flow field 107. In more severe cases, the temperature of the coolant flowing through the direct flow field 108 may be higher than that of the electronic components in that area, resulting in no cooling efficiency and even causing the coolant to heat the electronic components. In order to solve the above situation, electronic elements such as power converters or transformers in the chassis 102 can be arranged according to the flow direction of the coolant. For example, following the coolant flow direction, electronic components that generate more heat can be placed at the coolant output terminal 102b, which is closer to the direct flow field 108, rather than at the coolant input terminal 102a. This means that heat-generating components, such as transformers or MOSFETs (Metal-Oxide-Semiconductor Field-Effect Transistors), should be positioned near the coolant output terminal 102b.

In order to improve the cooling efficiency and avoid the problem of excessively high temperature of the coolant in the direct-flow field 108, another embodiment (as shown in FIG. 1) illustrates at least one bypass flow field 109 (indicated by dashed lines) in addition to the direct flow fields 107 and 108 within the chassis 102. The bypass-flow field 109 (indicated by dotted lines), for example, located in the vicinity of the heat-generating electronic elements in the direct-flow field 108, so as to allow a portion of the coolant with a lower temperature to enter the flow-through field 108 directly. The bypass coolant mixes with the coolant in the direct-flow field 108 through the bypass-flow field 109, and the temperature of the coolant in such area is reduced. The heat exchange efficiency between the coolant and the electronic elements in the area of the flow-through field 108 is increased. Therefore, the partition 106 in this embodiment does not limit the form in which the coolant flows inside the chassis 102.

Referring to FIGS. 1 and 2A, the partition 106 is, for example, a solid elongated plate that separates the area into the two direct-flow fields 107 and 108. The partition 106 has a length L and a height H. The length L is substantially greater than the height H. The dimensions of the length L and the height H of the partition 106 may correspond to the dimensions of the length and the height of the chassis 102, e.g., the length L of the partition 106 is about one-half or two-thirds of the length of the chassis 102, or the height H of the partition 106 is about the height of the chassis 102 or one-half or two-thirds of the height of the chassis 102, alternatively, the height H of the partition 106 may vary depending on the shape of the partition 106.

Referring to FIGS. 1 and 2B, the partition includes, for example, two partition unit 106a and 106b composed of solid elongate plates dividing the area into the two direct-flow fields 107 and 108, and can be arranged along a long side 103 of the chassis 102. The length of each of the partition units 106a and 106b is approximately one-half or less of the length of the chassis 102. The height of each of the partition units 106a and 106b is approximately equal to the height of the chassis 102 or one-half or two-thirds of the height of the chassis 102. Meanwhile, the total length of the partition units 106a and 106b projected in the direction of the long side 103 of the chassis 102 is approximately half or two-thirds of the length of the chassis 102.

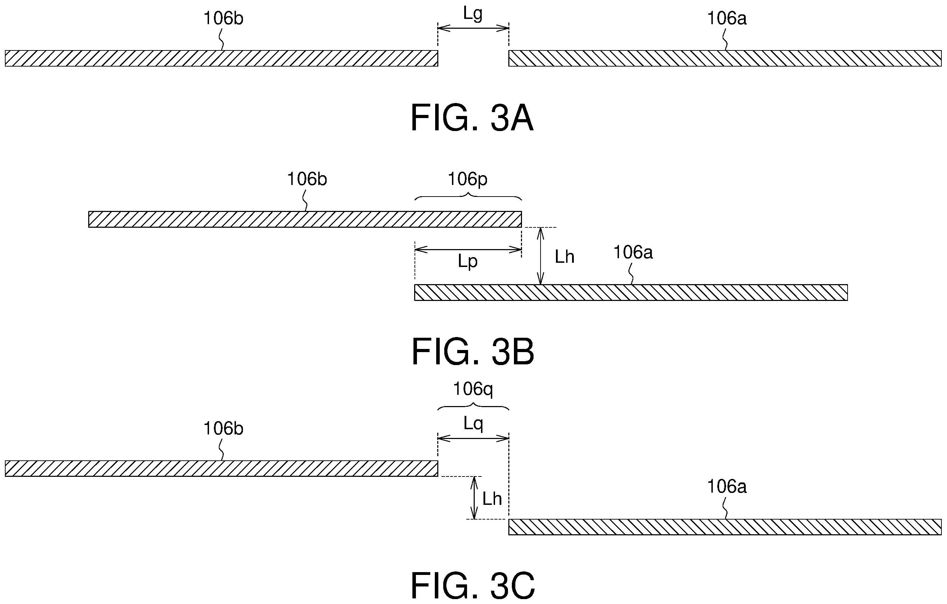

Referring to FIGS. 3A to 3C, schematic diagrams of partition configurations in accordance with three embodiments of the present invention are illustrated, respectively. In FIG. 3A, two partition units 106a and 106b are aligned substantially along the direction of the long side 103 of the chassis 102 (shown in FIG. 1). The two partition units 106a and 106b may be physically connected or spaced apart by a distance Lg, which is approximately 0% to 25% of the length of the chassis 102. In FIGS. 3B and 3C, the two partition units 106a and 106b are arranged substantially in parallel along the direction of the long side 103 of the chassis 102 (shown in FIG. 1), and the two partition units 106a and 106b may partially overlap or do not overlap in the horizontal projection direction of the long side 103. As shown in FIG. 3B, the length Lp of the partially overlapping region 106p of the two partition units 106a and 106b may be one-half, one-quarter or less of the length of the chassis 102. In addition, the horizontal distance Lh between the two partition units 106a and 106b may be approximately one-fourth or less of the width of the chassis 102. As shown in FIG. 3C, when the two partition units 106a and 106b are arranged in parallel but do not overlap, the length Lq of non-overlapping region 106q between the two partition units 106a and 106b may be one-quarter or less of the length of the chassis 102. In addition, the horizontal distance Lh between the two partition units 106a and 106b is approximately one-fourth or less of the width of the chassis 102. In addition, the total length of the partition units 106a and 106b in the projections direction of the long side 103 of the chassis 102 is about one-half or two-thirds of the length of the chassis 102. The aforementioned partition 106, partition units 106a and 106b may also be referred to as a fluid divider or a fluid dividing element, and the area between the two partition units 106a and 106b may be defined as the area of the bypass-flow field 109.

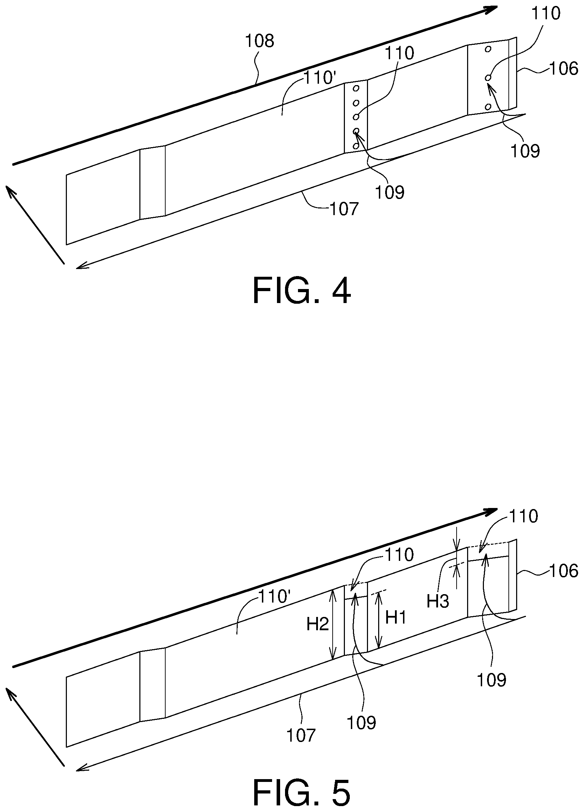

Referring to FIGS. 4 to 10, schematic diagrams of partition configurations in accordance with seven embodiments of the present invention are illustrated, respectively. The partition 106 is configured with a bypass-flow device to generate a bypass-flow field 109 between the direct-flow fields 107 and 108, so that the coolant can flow from the direct-flow field 107 to the direct-flow field 108 by flowing through the bypass-flow device. The coolant temperature in the direct-flow field 108 is thus reduced.

In FIG. 4, the bypass-flow device of the partition 106 may include an aperture 110, a plurality of apertures 110 arranged in a horizontal direction of the partition 106, or a plurality of apertures 110 arranged in a vertical direction of the partition 106. In FIG. 4, the number of apertures 110 is not limited, and the shape of the apertures 110 may be round or other shapes. The openings 110 form a bypass-flow field 109 between the direct-flow fields 107 and 108 (as shown in FIG. 1) so that a portion of the coolant can flow through the openings 110 or have a disturbing effect within the chassis 102. In one embodiment, the percentage of the area of the openings 110 to the area of the unopened area 110' is between about 5% and 50%. The area of the partition 106 other than the openings 110 is referred to as the unopened area 110'. In one embodiment, the apertures 110 may be located away from the coolant input terminal 102a and the coolant input terminal 102b, but the invention is not limited thereto.

In FIG. 5, the bypass-flow device of the partition 106 may include an aperture 110 or a plurality of apertures 110, which are located substantially on the top surface of the partition 106 such that the height H1 of the partition 106 at the aperture 110 is lower than the height H2 of the unopened area 110' so as to form a notch on the top of the partition 106. In FIG. 5, the height H3 at which the partition 106 descends at the aperture 110 is between about 5% and 50% of the height H2 of the partition 106 at the unopened area 110'. The top of the partition 106 may have a concave-convex shape. In one embodiment, the aperture 110 may be located away from the coolant input terminal 102a and the coolant output terminal 102b, but the present invention is not limited thereto.

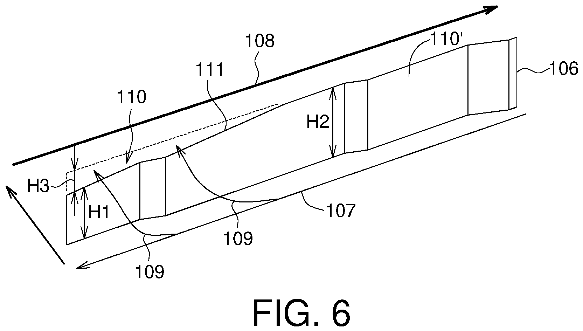

In FIG. 6, the bypass-flow device of the partition 106 may include an aperture 110, which is located substantially on the top surface of the partition 106 so that the height H1 of the partition 106 at the aperture 110 is lower than the height H2 of the unopened area 110'. In FIG. 6, the top surface of the partition 106 has, for example, a bevel 111 extending downward from one side of the partition 106 to the other side to form a slanted surface of the partition 106. Accordingly, the partition 106 may taper from the unopened area 110' to the area of the aperture 110 in height, and the height H3 at which the partition 106 descends at the aperture 110 is between about 20% and 50% of the height H2 of the partition 106 at the unopened area 110'. The aperture 110 may be located away from the coolant input terminal 102a and coolant output terminal 102b, but the present invention is not limited thereto.

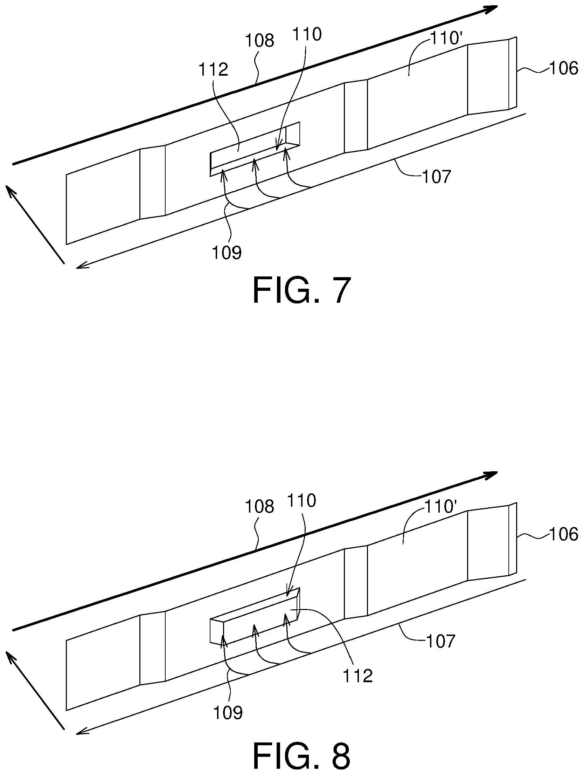

In FIGS. 7 and 8, the bypass-flow device of the partition 106 may include at least one aperture 110, and the partition 106 has a folded plate 112 at a side of the aperture 110. The folded plate 112 protrudes from one side of the partition 106 to the other side of the partition 106. That is, the folded plate 112 may protrude from one of the direct-flow fields 107 and 108 (see FIG. 1) to the other one of the direct-flow fields 107 and 108 (see FIG. 1) so that the folded plate 112 is not coplanar with the partition 106 (i.e., the unopened area 110'). In FIGS. 7 and 8, the folded plate 112 is bent and shaped along a horizontal direction of the partition 106, and the area of the folded plate 112 protruding from one side of the partition 106 to the other side of the partition 106 is between about 20% and 80% of the area of the partition 106. In one embodiment, the aperture 110 may be located away from the coolant input terminal 102a and coolant output terminal 102b, but the present invention is not limited thereto.

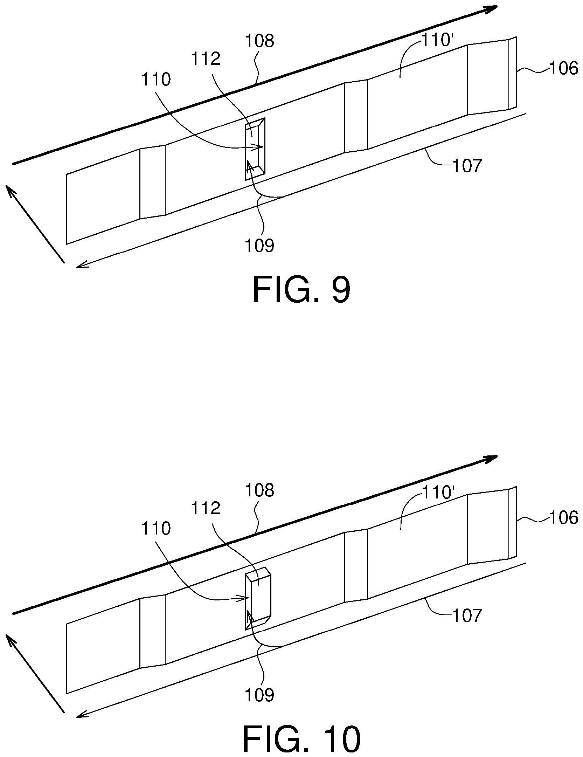

In FIGS. 9 and 10, the bypass-flow device of the partition 106 may include at least one aperture 110, and the partition 106 has a folded plate 112 at a side of the aperture 110. The folded plate 112 protrudes from one side of the partition 106 to the other side of the partition 106. That is, the folded plate 112 may protrude from one of the direct-flow fields 107 and 108 (see FIG. 1) to the other one of the direct-flow fields 107 and 108 (see FIG. 1) so that the folded plate 112 is not coplanar with the partition 106 (i.e., the unopened area 110'). In FIGS. 9 and 10, the folded plate 112 is bent and shaped along a vertical direction of the partition 106, and the area of the folded plate 112 protruding from one side of the partition 106 to the other side of the partition 106 is between about 20% and 80% of the area of the partition 106. In one embodiment, the aperture 110 may be located away from the coolant input terminal 102a and the coolant output terminal 102b, but the present invention is not limited thereto.

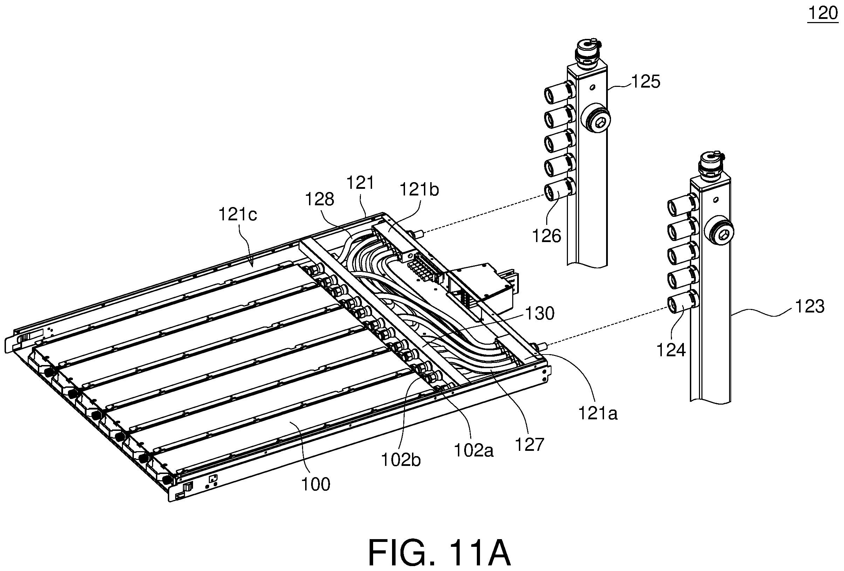

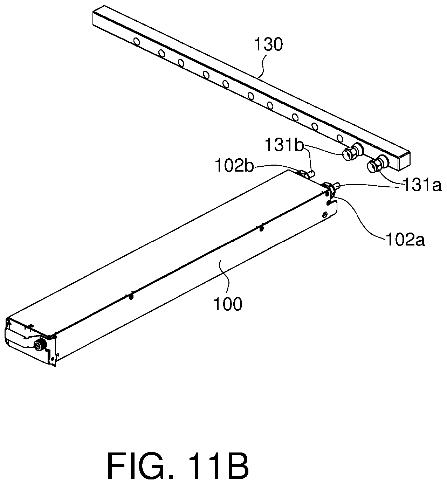

Referring to FIGS. 11A and 11B, a schematic diagram and a partially enlarged diagram of a liquid-cooled power supply cabinet 120 in accordance with an embodiment of the present invention are illustrated, respectively. The liquid-cooled power supply cabinet 120 includes a shelf 121, a coolant input manifold 123, a coolant output manifold 125, at least one liquid-cooled power supply chassis 100, at least one first conduit 127, and at least one second conduit 128. Any number of shelves 121, for example, 10 to 30, can be connected to each of the coolant input manifold 123 and the coolant output manifold 125; and any number of liquid-cooled power supply chassis 100, such as 5 to 10, may be placed on each shelf 121 as demand. For the detailed structure of the liquid-cooled power supply chassis 100, please refer to FIGS. 1 to 10 and will not be repeated herein.

Relative to each liquid-cooled power supply chassis 100, the shelf 121 has a reservoir 121c, a first port 121a, and a second port 121b. In addition, relative to each liquid-cooled power supply chassis 100, the first conduit 127 is connected between the first port 121a and the coolant input terminal 102a, and the second conduit 128 is connected between the second port 121b and the coolant output terminal 102b.

In addition, relative to each shelf 121, the coolant input manifold 123 has an inlet end 124, which is connected to the first port 121a. Relative to each shelf 121, the coolant output manifold 125 has an outlet end 126, which is connected to the second port 121b. In other words, the coolant flows in a manner generally as follows. The coolant flows into the first port 121a through the inlet end 124 of the coolant input manifold 123, and then flows into the coolant input terminals 102a of each liquid-cooled power supply chassis 100 through the first port 121a and the plurality of first conduits 127 so as to circulate the coolant in each liquid-cooled power supply chassis 100, and the coolant absorbs the heat of the electronic elements in the chassis 100, and carries away the heat energy by the flow of the coolant. The coolant absorbs heat from the electronic elements in the chassis 100 and carries away heat energy by flowing the coolant. The coolant then flows to a plurality of second conduits 128 and the second port 121b through the coolant output terminal 102b of each liquid-cooled power supply chassis 100, and then flows to the outlet end 126 of the coolant output manifold 125 through the second port 121b. The coolant transfers the heat energy to the heat exchanger (not shown) located outside the liquid-cooled power supply cabinet 120 and returns to the liquid-cooled power supply cabinet 120 through the cooling recycle to continue absorbing the heat energy of the electronic elements.

Referring to FIGS. 11A and 11B, in one embodiment, the liquid-cooled power supply cabinet 120 may include a conduit mounting bracket 130 disposed on the shelf 121. The conduit mounting bracket 130 allows an installer to quickly mount the liquid-cooled power supply cabinet 100 on the shelf 121 to facilitate subsequent maintenance and replacement.

Referring to FIGS. 11A and 11B, for each liquid-cooled power supply chassis 100, the conduit mounting bracket 130 includes a quick connector 131a connected between the first conduit 127 and the coolant input terminal 102a. In addition, the conduit mounting bracket 130 includes a quick connector 131b connected between the second conduit 128 and the coolant output terminal 102b. The quick connectors 131a and 131b are quick connectors for liquid-cooled coupling, preferably blind plug-in quick connectors, such as UQDB-02 or UQDB-04 standard connectors, which can be used for tool-less installation of liquid-cooled systems.

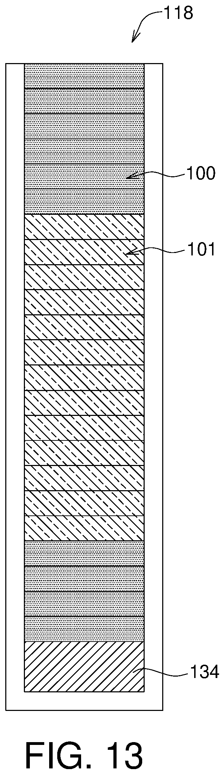

Referring to FIGS. 12 and 13, schematic diagrams of a liquid-cooled power supply cabinet 120 (or server cabinet 122) with a built-in coolant distribution unit 132 in accordance with an embodiment of the present invention are illustrated, respectively. In one embodiment, two or more liquid-cooled power cabinets 120 (or server cabinets 122) may be connected to each other by the built-in coolant distribution unit 132 in a configuration as described below.

Referring to FIG. 12, the coolant distribution unit 132 includes at least one coolant distribution tube 133 and at least one liquid pump unit 134. The coolant distribution tube 133 is connected between two or more liquid-cooled power supply cabinets 120 (or server cabinets 122) to transfer coolant into and/or out of the liquid-cooled power supply cabinets 120 (or server cabinets 122). In addition, the liquid pump unit 134 is connected to the coolant input manifold 123 and the coolant output manifold 125 (refer to FIG. 11A) of each liquid-cooled power supply cabinet 120 (or server cabinet 122) to transfer coolant into and/or out of each liquid-cooled power supply chassis 100 (or server chassis 101). In one embodiment, the liquid pump unit 134 may be disposed at the bottom of each liquid-cooled power supply cabinet 120 (or server cabinet 122), and the liquid pump unit 134 may be connected to each of the liquid coolant input manifold 123 and the liquid coolant output manifold 125 (refer to FIG. 11A) via the coolant distribution tube 133 to form a cooling cycle loop. The power for the liquid pump unit 134 may be provided by the liquid-cooled power supply cabinet 120.

Referring to FIG. 13, the liquid-cooled power supply chassis 100 and the server chassis 101 may be placed together in a cabinet to form a hybrid cabinet 118, and the liquid pump unit 134 may be disposed at the bottom of the hybrid cabinet 118, and the liquid pump unit 134 may be directly connected to each of the coolant input manifold 123 and the coolant output manifold 125 (refer to FIG. 11A) to form a cooling cycle loop. The power for the liquid pump unit 134 may be provided by the liquid-cooled power supply chassis 100.

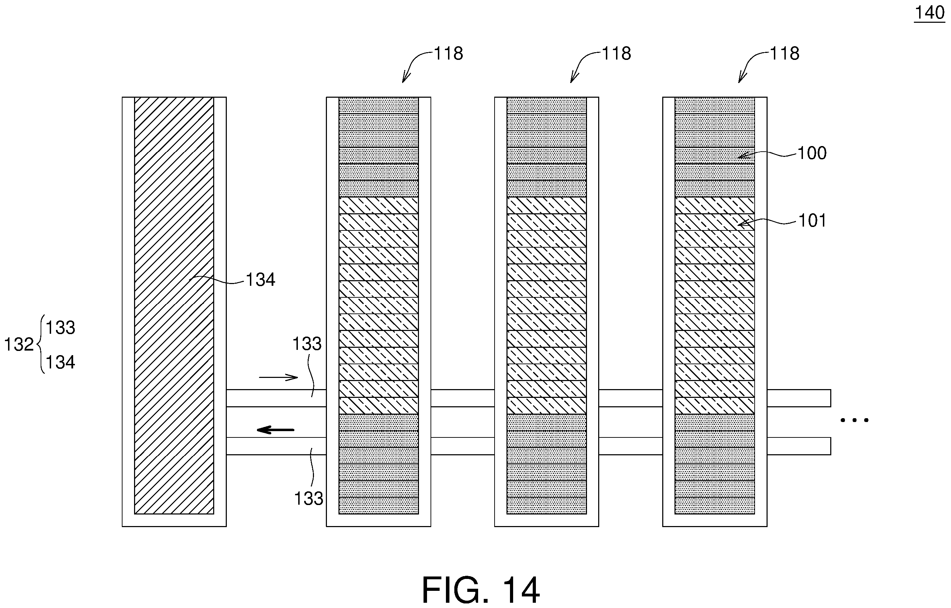

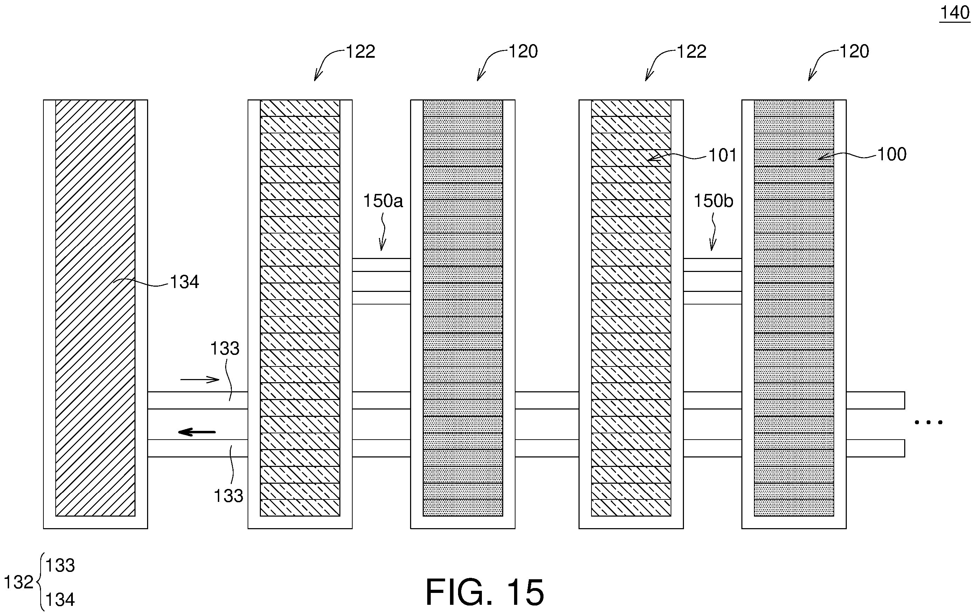

Referring to FIGS. 14 and 15, schematic diagrams of a data center cooling system 140 with an external coolant distribution unit 132 in a free-standing cabinet or a hybrid cabinet in accordance with two embodiments of the present invention are illustrated, respectively. Referring to FIG. 14, the coolant distribution unit 132 is disposed independent of the two or more hybrid cabinets 118 (composed of the liquid-cooled power supply chassis 100 and the server chassis 101), and the coolant distribution unit 132 comprises at least one coolant distribution tube 133 and at least one liquid pump unit 134. The difference is that the liquid pump unit 134 is disposed outside the two or more hybrid cabinets 118 to reduce occupied space therefrom. The liquid pump unit 134 may be connected to each of the coolant input manifold 123 and the coolant output manifold 125 (refer to FIG. 11A) of each hybrid cabinet 118 via the coolant distribution tubes 133 to form a cooling cycle loop. The coolant distribution unit 132 may further include a liquid-to-liquid heat exchanger (not shown) or a liquid-to-gas heat exchanger (not shown) to transfer heat from the coolant distribution tubes 133 to an external environment. The two or more hybrid cabinets 118 described above may include any number of liquid-cooled power supply chassis 100 and any number of server chassis 101 respectively, such as 10 to 30, and when the liquid-cooled power supply chassis 100 is placed in the same cabinet as the server chassis 101, as shown in FIG. 14, the power of the server chassis 101 may be supplied by the power supply chassis 100 in the same cabinet. In addition, in FIG. 15, the liquid-cooled power supply chassis 100 and the server chassis 101 may also be independently configured in different cabinets to form separate power cabinet 120 and server cabinet 122. The power from the liquid-cooled power supply cabinet 120 to the server cabinet 122 can be transmitted via the power cables 150a and 150b.

Referring to FIG. 11A and FIGS. 14 and 15, the liquid-cooled power supply chassis 100 and the server chassis 101 have respective coolant input terminals 102a (hereinafter referred to as the first coolant input terminal and the second coolant input terminal) and coolant output terminals 102b (hereinafter referred to as the first coolant output terminal and the second coolant output terminal). In addition, the coolant input manifold 123 has at least two inlet ends 124 that are connected to the first coolant input terminal and the second coolant input terminal, respectively. In addition, the coolant output manifold 125 has at least two outlet ends 126, which are connected to the first coolant output terminal and the second coolant output terminal. The configuration of the liquid-cooled power supply chassis 100 and the server chassis 101 with respect to the coolant input terminal 102a, the coolant output terminal 102b, the coolant input manifold 123, and the coolant output manifold 125 is similar to that of FIGS. 11A and 11B, which can be referred to together and will not be repeated herein.

In addition, the coolant distribution unit 132 can transfer coolant into and/or out of the liquid-cooled power supply chassis 100 and the server chassis 101 through the coolant input manifold 123 and the coolant output manifold 125 described above and will not be repeated herein.

In addition, referring to FIGS. 11A and 15, the liquid-cooled power supply cabinet 120 and the server cabinet 122, in the case of a stand-alone cabinet, may have respective coolant distribution units 132 (hereinafter referred to as the first coolant distribution unit and the second coolant distribution unit). The liquid-cooled power supply cabinet 120 may be configured with a first coolant distribution unit that transfers coolant into the plurality of liquid-cooled power supply chassis 100 via a first coolant input manifold 123, and transfers coolant out of the liquid-cooled power supply chassis 100 via a first coolant output manifold 125. In addition, the server cabinet 122 may be configured with a second coolant distribution unit that transfers coolant into the plurality of server chassis 101 via a second coolant input manifold 123, and transfers coolant out of the server chassis 101 via a second coolant output manifold 125.

On the other hand, in FIG. 15, the liquid-cooled power supply cabinet 120 may also be configured with the coolant distribution unit 132 that directly transfers coolant to the liquid-cooled power supply cabinet 120 via the first coolant input manifold 123, and then transfers coolant out of the liquid-cooled power supply cabinet 120 via the first coolant output manifold 125.

In addition, in FIG. 15, the server cabinet 122 can also be configured with the coolant distribution unit 132 that directly transfers coolant to the server cabinet 122 via the second coolant input manifold 123, and then transfers coolant out of the server cabinet 122 via the second coolant output manifold 125. The coolant distribution unit 132 is configured in a manner similar to that in FIG. 14, which can be referred to together and will not be repeated here.

While the invention has been described by way of example and in terms of the preferred embodiment(s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A liquid-cooled power supply chassis (100), comprising:
a chassis (102) having a coolant input terminal (102a) and a coolant output terminal (102b);
at least a power supply (104) disposed in the chassis (102); and
at least a partition (106) provided in the chassis (102), the partition (106) separating the coolant input terminal (102a) from the coolant output terminal (102b).

2. The liquid-cooled power supply chassis (100) of claim 1, wherein the chassis (102) has a long side (103) and a short side (105), and the partition (106) extends along the long side (103) and disposed between the coolant input terminal (102a) and the coolant output terminal (102b) to divide an interior space of the chassis (102) into at least two direct-flow fields (107, 108).

3. The liquid-cooled power supply chassis (100) of claim 2, wherein the partition (106) comprises two partition units (106a, 106b) aligned to each other and arranged along the long side (103) of the chassis (102).

4. The liquid-cooled power supply chassis (100) of claim 2, wherein the partition (106) comprises two partition units (106a, 106b) arranged in parallel along the long side (103) of the chassis (102), and the two partition units (106a, 106b) partially overlap or do not overlap in a horizontal projection direction of the long side (103).

5. The liquid-cooled power supply chassis (100) of claim 2, wherein the coolant input terminal (102a) and the coolant output terminal (102b) are configured on the short side (105) of the chassis (102), the coolant input terminal (102a) corresponds to one of the direct-flow fields (107, 108) on one side of the partition (106), and the coolant output terminal (102b) corresponds to another one of the direct-flow fields (107, 108) on another side of the partition (106).

6. The liquid-cooled power supply chassis (100) of claim 5, wherein the partition (106) comprises at least a bypass-flow device for forming a bypass-flow field (109) between the direct-flow fields (107, 108).

7. The liquid-cooled power supply chassis (100) of claim 6, wherein the bypass-flow device comprises an aperture (110) at which a height of the partition (106) is lower than a height of the partition without the aperture (110').

8. The liquid-cooled power supply chassis (100) of claim 7, wherein the partition (106) has a height that decreases from a side of the partition without the aperture (110) to another side of the partition with the aperture (110).

9. The liquid-cooled power supply chassis (100) of claim 6, wherein the bypass-flow device comprises a folded plate (112) provided on the partition (106), the folded plate (112) protruding from one of the direct-flow fields (107, 108) to another of the direct-flow fields (107, 108).

10. The liquid-cooled power supply chassis (100) of claim 9, wherein the folded plate (112) is bent and shaped along a horizontal direction or a vertical direction of the partition (106).

11. A liquid-cooled power supply cabinet (120), comprising:
a shelf (121) having a reservoir (121c), a first port (121a), and a second port (121b);
a coolant input manifold (123) having at least an inlet end (124) connected to the first port (121a);
a coolant output manifold (125) having at least an outlet end (126) connected to the second port (121b);
at least a liquid-cooled power supply chassis (100) according to claim 1, provided in the reservoir (121c) of the shelf (121);
at least a first conduit (127) connected between the first port (121a) and the coolant input terminal (102a); and
at least a second conduit (128) connected between the second port (121b) and the coolant output terminal (102b).

12. The liquid-cooled power supply cabinet (120) of claim 11, further comprising a conduit mounting bracket (130) disposed on the shelf (121), the conduit mounting bracket (130) comprising a quick connector coupling (131a) between the first conduit (127) and the coolant input terminal (102a).

13. The liquid-cooled power supply cabinet (120) of claim 11, further comprising a conduit mounting bracket (130) disposed on the shelf (121), the conduit mounting bracket (130) comprising a quick connector coupling (131b) between the second conduit (128) and the coolant output terminal (102b).

14. The liquid-cooled power supply cabinet (120) of claim 11, further comprising a coolant distribution unit (132), wherein the coolant distribution unit (132) transfers coolant into and out of the liquid-cooled power supply cabinet (120) via a coolant distribution tube (133).

15. The liquid-cooled power supply cabinet (120) of claim 14, wherein the coolant distribution unit (132) further comprises a liquid pump unit (134) connecting the coolant inlet manifold (123) and the coolant output manifold (125).
